# EUROPÄISCHE PATENTANMELDUNG

(11) **EP 4 203 628 A1**
(43) Veröffentlichungstag der Anmeldung: **28.06.2023**
(21) Anmeldenummer: 22211713.7
(22) Anmeldetag: 06.12.2022
(51) Int. Cl.: H05K 1/14, H05K 7/14

(54) **MODULARE LEITERPLATTENANORDNUNG UND VERFAHREN ZUR MONTAGE EINER LEITERPLATTENANORDNUNG**

(30) Priorität: 27.12.2021 DE 102021006359
(71) Anmelder: ebm-papst Mulfingen GmbH & Co. KG, 74673 Mulfingen (DE)
(72) Erfinder: STURM, Michael, 97980 Bad Mergentheim-Rot (DE); HANSELMANN, Steffen, 74532 Ilshofen (DE)
(74) Vertreter: Staeger & Sperling Partnerschaftsgesellschaft mbB

(57) **Zusammenfassung**

Die vorliegende Erfindung betrifft eine Leiterplattenanordnung (100) zur Ausbildung einer Motorsteuerung in einem Motorgehäuse (50) bestehend aus wenigstens einer ersten bestückten Leiterplatte (LP1) und einer zweiten bestückten Leiterplatte (LP2) ausgebildet mit einer Mehrzahl an Kontaktelementen (20), ausgebildet zum Zusammenstecken in Steckrichtung (S) zur Herstellung einer wieder lösbaren elektrischen Verbindung mit korrespondierenden Gegenkontakten (10) der ersten Leiterplatte (LP1), sowie einer plattenförmigen Ausricht- und Führungseinrichtung (LP3), die von der ersten Leiterplatte (LP1) in Steckrichtung (S) hin zur zweiten Leiterplatte (LP2) hervorsteht und im Montagezustand, wenn sich die Kontaktelemente (20) der zweiten Leiterplatte (LP2) vollständig im gesteckten Zustand mit den Gegenkontakten (10) der ersten Leiterplatte (LP1) befinden, mit einem endseitigen Abschnitt (30) durch einen Spalt (21) in der zweiten Leiterplatte hindurch ragt, wobei die Kontaktelemente (20) mit einer unterschiedlichen Länge (L1, L2, L3,...) von der zweiten Leiterplatte (20) hervorstehen.

## Beschreibung

Die Erfindung betrifft eine modulare Leiterplattenanordnung aus zwei bzw. mehreren Leiterplatten und ein Verfahren zur Montage einer solchen Leiterplattenanordnung.

Leiterplattenverbinder dienen hauptsächlich der Herstellung elektrisch leitender Verbindungen zwischen zwei Leiterplatten, bspw. um einen unkompliziert herzustellenden modularen Aufbau aus verschiedenen Leiterplatten, insbesondere Platinen, zu erreichen. Teilweise ist es auch wünschenswert, für eine modulare Zusammenstellung verschiedener Leiterplatten unter Herstellung elektrisch leitender Verbindungen gleichzeitig eine mechanische Kopplung zwischen den Leiterplatten mittels eines Leiterplattenverbinders zu bewerkstelligen.

Eine beispielhafte elektrisch leitende Verbindung sowie ebenfalls eine mechanische Kopplung zwischen zwei Leiterplatten zeigt die Druckschrift DE 10 2012 102 055 A1. Hierbei ist ein Verbindungselement vorgesehen, welches einen Brückenabschnitt aufweist, der sich im montierten Zustand an zwei Leiterplatten über die Stirnbereiche der beiden Leiterplatten erstreckt und weiterhin Einpresszonen aufweist, wobei jeweils eine der Einpresszonen in jeweils eine Bohrung der Leiterplatte eingepresst wird. Die Bohrungen der Leiterplatten sind an ihren inneren Mantelflächen elektrisch leitend. Hierdurch wird einerseits eine elektrische Kontaktierung zwischen den Bohrungen der beiden Leiterplatten erreicht, als auch eine mechanische Kopplung.

Im Stand der Technik sind ferner eine Vielzahl anderer Lösungen bekannt, die jeweils applikationsspezifische Besonderheiten aufweisen und sich insofern nicht ohne weiteres auf eine andere Applikation sinnvoll übertragen lassen. Häufig stellt bereits der fehlende oder begrenzte Bauraum einen limitierenden Faktor dar.

So steht für Motorsteuerungen, die im Motorgehäuse integriert werden, ebenfalls nur ein für den jeweiligen Motor spezifischer Bauraum zur Verfügung, der einerseits optimal genutzt werden sollte, andererseits auch technische Aspekte, wie zum Beispiel die Wärmeableitung bei der Konfektionierung zu berücksichtigen sind.

Insgesamt besteht damit ein Bedürfnis, einen einfachen, kostengünstig herstellbaren Aufbau einer Steuer-Einheit (insbesondere Motorsteuereinheit) bei vorgegebenem Gehäuse bzw. Gehäusevolumen zu realisieren und nach Möglichkeit eine Modularität zu realisieren. Dabei soll die Konzeption möglichst platzsparend sein und einen möglichst einfachen Montageprozess gewährleisten.

Es ist daher die Aufgabe der vorliegenden Erfindung, eine Leiterplattenanordnung (für eine Motosteuereinheit) bereitzustellen, welche Platz sparend aufgebaut und kostengünstig zu montieren ist. Dabei soll die Montage sicher sein und die elektrischen Kontakte dabei nicht beschädigt werden.

Eine weitere Herausforderung stellen die elektrischen Verbindungselemente, das heißt die Kontakte, mit denen die Leiterplatten einer Leiterplattenanordnung elektrisch verbunden werden, dar. Der Fachmann auf diesem Gebiet kennt neben den nichtlösbaren elektrischen Verbindungen, wie den Einpresskontakten, die beim Einpressen eine Kaltverschweißung in der Kontaktzone herstellen ferner auch wieder lösbare Verbindungstechniken, die mit typischen Steck- und Buchsenkontakten herstellbar sind. Dabei wirken in aller Regel Stiftkontakte mit federnden Buchsenkontakten zusammen. Bei mehrpoligen oder hochpoligen Kontaktanordnungen summieren sich dabei die Steck- und Ziehkräfte beim Zusammenstecken und Trennen der Steckpartner, so dass es regelmäßig zu unerwünscht hohen Gesamtsteckkräften kommt. Neben der Einzelsteckkraft eines Kontaktpaares, bedingt durch Form und Geometrie der Kontakte sowie deren Kontaktmaterial, bestimmt auch die Toleranzlage der Kontakte zueinander bei mehr- oder hochpoligen Kontaktanordnungen die Steck- und Ziehkräfte. Teilweise werden diese durch eine schwimmende Lagerung der Kontakte reduziert, wobei eine solche schwimmende Lagerung nicht immer gewünscht ist und auch technisch aufwändiger in der Herstellung ist.

Ein weiteres daraus resultierendes Problem liegt darin, dass ein Monteur beim Zusammenstecken der Leiterplatten mit mehr-oder hochpoligen elektrischen Verbindungskontakten erwartungsgemäß eine höhere Steckkraft erwartet und daher nicht auf einfache Weise anhand der Steckkraft detektieren kann, ob beim Zusammenstecken ein Kontakt beschädigt oder verbogen wurde. Bekannte Lösungen verwenden zum Beispiel hierzu eine Fügevorrichtung mit einer (Hebel-) Presse an einem eigens dafür eingerichteten Montagetisch, welche neben hohem Kostenaufwand auch das Risiko einer unerkannten Kontaktbeschädigung beim Zusammenfügen der Leiterplatten beim Hebelpressen verursachen kann.

Somit ist es eine weitere Aufgabe der vorliegenden Erfindung die Montage solcher Leiterplattenanordnungen zu verbessern und zu erleichtern und Beschädigungen durch Montagefehler zu vermeiden.

Die genannten Aufgaben werden erfindungsgemäß durch die Merkmale der unabhängigen Ansprüche gelöst.

Eine Grundidee der vorliegenden Erfindung betrifft die Ausnutzung des Bauraums im Motorgehäuse mittels spezieller Verschachtelung der Leiterplatten, ferner die Gestaltung unterschiedlich langer elektrischer Kontakte, um diese sequentiell nacheinander, d.h. in Steckrichtung betrachtet, versetzt zueinander, jeweils abhängig von ihrer individuellen Kontaktlänge in Eingriff mit dem jeweils korrespondierenden Buchsenkontakt zu bringen und darüber hinaus eine Ausricht- und Führungseinrichtung vorzusehen, um die Vorzentrierung der Kontakte einerseits und das Führen beim Zusammenstecken der Leiterplatten andererseits zu gewährleisten.

Erfindungsgemäß wird hierzu eine Leiterplattenanordnung zur Ausbildung einer Motorsteuerung in einem Motorgehäuse bestehend aus wenigstens einer ersten bestückten Leiterplatte und einer zweiten bestückten Leiterplatte ausgebildet mit einer Mehrzahl an Kontaktelementen vorgesehen, ausgebildet zum Zusammenstecken in Steckrichtung der Kontakte zur Herstellung einer wieder lösbaren elektrischen Verbindung mit korrespondierenden Gegenkontakten der ersten Leiterplatte, sowie einer plattenförmigen Ausricht- und Führungseinrichtung (die bevorzugt ebenfalls eine Leiterplatte ist), die von der ersten Leiterplatte in Steckrichtung hin zur zweiten Leiterplatte hervorsteht und im Montagezustand, wenn sich die Kontaktelemente der zweiten Leiterplatte vollständig im gesteckten Zustand mit den Gegenkontakten der ersten Leiterplatte befinden, mit einem endseitigen Abschnitt durch einen Spalt in der zweiten Leiterplatte hindurch ragt, wobei die Kontaktelemente erfindungsgemäß mit einer unterschiedlichen Länge von der zweiten Leiterplatte hervorstehen bzw. aus dieser heraus ragen.

Als bestückte Leiterplatten sind solche Leiterplatten zu verstehen, die mit den für ihre Funktion bestückten elektrischen und elektronischen Bauelementen, insbesondere passiven und aktiven Bauelementen auf wenigstens einer Bestückungsseite bestückt sind.

Bei der dieser Erfindung zu Grunde liegenden Applikation ist bevorzugt vorgesehen, dass die erste Leiterplatte als übergeordnete Hauptplatine der Motorsteuerung ausgebildet ist. Weiter bevorzugt ist es, dass die zweite Leiterplatte als DrosselLeiterplatte ausgebildet ist und ebenfalls bevorzugt ist es, wenn die dritte Leiterplatte, die mit er ersten Leiterplatte elektrisch und mechanisch verbunden ist und von dieser stehend hervorsteht, als Motor-Controller bzw. Controllerplatine ausgebildet ist.

Grundsätzlich lassen sich aber auch Leiterplatten anderer Funktion in der erfindungsgemäßen Weise verbinden. Durch diese verschachtelte Anordnung wird der Bauraum optimal genutzt, während gleichzeitig eine Leiterplatte als Führungs- und Ausrichtmittel wirkt, um die Montage zu bewerkstelligen und ein Ausrichten der Kontakte zu ermöglichen.

Aufgrund der unterschiedlichen Kontaktlängen wird die Gesamt-Steckkraft reduziert, da die Kräfte sozusagen sukzessive nacheinander wirken, sobald der jeweils nacheilende Kontakt mit seinem Gegenkontakt in Eingriff kommt. Hierzu wird folgende Ausgestaltung bevorzugt. Bei den n Kontakten mit n > 2, die von der zweiten Leiterplatte mit jeweils unterschiedlicher Länge hervorstehen, sind die Längenunterschiede zwischen den Kontakten jeweils so gewählt ist, dass diejenigen Kontakte mit einer Länge zwischen der Länge des kürzesten und längsten Kontaktes sich in ihrer Länge jeweils um einen äquidistanten Längenunterschied ΔL unterscheiden, so dass beim Zusammenstecken die n Kontakte sukzessive nacheinander in Eingriff kommen. Anders ausgedrückt, besitzt ein erster Kontakt die Länge L, ein zweiter Kontakt die Länge L + ΔL, ein dritter Kontakt die Länge L + 2 × ΔL, usw.

In einer vorteilhaften Ausgestaltung der Erfindung ist somit vorgesehen, dass die plattenförmigen Ausricht- und Führungseinrichtung ebenfalls eine Leiterplatte, insbesondere eine bestückte Leiterplatte ist, wobei mit Vorteil der endseitige Abschnitt dieser Leiterplatte unbestückt ist. Dies ist aber (je nach Ausführung und Breite des Spaltes) nicht zwingend erforderlich. Die Seitenkanten dieser Ausricht- und Führungseinrichtung bzw. dieser stehenden Leiterplatte wirken mit dem Spalt in der zweiten Leiterplatte zusammen. Die Führung wird sozusagen im Randbereich bewirkt, so dass grundsätzlich eine gute Flächennutzung der dritten Leiterplatte möglich ist.

In einer bevorzugten Ausgestaltung der Erfindung ist hierzu vorgesehen, dass die Spaltbreite B des Spaltes in der zweiten Leiterplatte, so bestimmt ist, dass eine Ausrichtung und Führung des endseitigen Abschnitt der Ausricht- und Führungseinrichtung (bzw. der dritten Leiterplatte) beim Zusammenstecken der ersten und zweiten Leiterplatten bewirkt wird, insbesondere die Breite so bestimmt ist, das die Plattendicke der Leiterplatte im Bereich des endseitigen Abschnitt nur geringfügig kleiner als die Spaltbreite B ist. Das verbleibende Spiel lässt sich durch geeignete Abstimmung des Spaltmaßes zur Plattendicke wunschgemäß einstellen.

In einer weiteren bevorzugten Ausgestaltung der Erfindung ist vorgesehen, dass die Spaltbreite B nur im Randbereich wie zuvor beschrieben ist und in einem Bereich zwischen den beiden Spaltenden 21a, 21b (in Spaltlängsrichtung betrachtet) größer, insbesondere 1,5 bis 2,5 mal so groß gewählt ist, wie im Führungsbereich an den Spaltenden. Hierdurch kann das Zusammenstecken vereinfacht werden, da nur geringere Wirkabschnitte zusammenwirken und ein Verklemmen und Verkanten, insbesondere bei klein gewähltem Führungsspiel besser verhindert wird. Ein weiterer Vorteil besteht darin, dass die dritte Leiterplatte auch bestückt werden kann mit Bauteilen, die dann durch den breiteren Spaltbereich beim Zusammenstecken hindurch gelangen können.

Ebenfalls von Vorteil ist es, wenn die sich gegenüberliegenden Seitenkanten der Ausricht- und Führungseinrichtung (bzw. der dritten Leiterplatte) im Bereich des endseitigen Abschnitt nicht parallel zueinander verlaufen, sondern vorzugsweise als Einführschräge unter einem schrägen Winkel zur Steckrichtung aufeinander zu laufen. Diese Einführschrägen erleichtern weiter die Montage, so dass das Einfädeln der dritten Leiterplatte in den Spalt der zweiten Leiterplatte vereinfacht wird. Die Geometrien der Seitenkanten sind im weiteren Verlauf so gewählt, insbesondere parallel verlaufend, dass dann die parallelen Seitenkanten im Spalt jeweils seitlich an den gegenüberliegenden Spaltenden geführt sind. Auf diese Weise erfolgt einerseits eine Führung quer zur und andererseits in Spaltlängenrichtung und es wird auf diese Weise eine gewünschte Ausrichtung der Leiterplatten und demnach der Kontakte insgesamt bewirkt.

Weiter von Vorteil ist es, wenn die Kontakte als Messerkontakte oder Flachkontakte mit jeweils zwei endseitig angeordneten flachen Kontaktzungen ausgebildet sind, die im zusammengesteckten Zustand der ersten und zweiten Leiterplatten (LP1, LP2) jeweils in einen dafür vorgesehenen Buchsenkontakt auf jeweils der ersten und zweiten Leiterplatte eintauchen und diese elektrisch kontaktieren. Weiter bevorzugt ist es, wenn um die Kontakte herum ein Kontaktträger angeordnet ist, der vorzugsweise ein Rastelement zur mechanischen Befestigung an einer der beiden Leiterplatten aufweist.

Für den Fall, dass die Kontakte in Kontaktreihen von z.B. drei oder mehreren Kontakten angeordnet sind, wird mit Vorteil ein gemeinsamer Kontaktträger für diese Kontakte verwendet.

Eine bevorzugte Anordnung der Leiterplatten ergibt sich wie folgt. Die erste und zweite Leiterplatte liegen im montierten Zustand in Parallelebenen zueinander und die dritte Leiterplatte bzw. die plattenförmigen Ausricht- und Führungseinrichtung ist in einer dazu lotrechten Ebene angeordnet, so dass man auch von einer stehenden Ausrichtung sprechen kann.

Ein weiterer Aspekt der vorliegenden Erfindung betrifft ein Elektronik-Gehäuse für einen Elektromotor aufweisend im Gehäuse zwischen einem Gehäusetopf und einem als Berührschutz ausgebildeten Gehäusedeckel eine wie zuvor beschriebene erfindungsgemäße Leiterplattenanordnung.

Ein weiterer Aspekt der vorliegenden Erfindung betrifft neben den genannten Vorrichtungen auch das Verfahren zur Montage einer solchen Leiterplattenanordnung mit den folgenden Schritten:
a. Manuelles (d.h. werkzeugloses) Einführen des endseitigen Abschnitts (der mit der ersten Leiterplatte verbundenen und von dieser hervorstehenden plattenförmigen Ausricht- und Führungseinrichtung in den Spalt in der zweiten Leiterplatte und Ausrichten der Kontakte der zweiten Leiterplatte zu den Gegenkontakten der ersten Leiterplatte
b. Manuelles (d.h. werkzeugloses) sukzessives Zusammenstecken der Kontakte mit den Gegenkontakten bis alle Kontakte vollständig eingesteckt und demnach die Leiterplatten verbunden sind.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt.

Es zeigen:
- Fig. 1: eine Anordnung von drei Leiterplatten (LP1, LP2, LP3) in Superposition in einem Vormontagezustand zusammen mit einem Motorgehäuse;
- Fig. 2: eine perspektivische Ansicht der zweiten Leiterplatte LP2 aus der Anordnung der Figur 1 ;
- Fig.3: eine Detailansicht des Vormontagezustands beim Zusammenführen der ersten und zweiten Leiterplatte, wobei die stehende dritte Leiterplatte als Führungsmittel wirkt;
- Fig. 4: ein Detail einer Schnittansicht, bei der drei Kontakte näher gezeigt sind;
- Fig. 5: eine perspektivische Ansicht auf einen Schnitt durch die Anordnung aus Figur 1 in einem Montageschritt;
- Fig. 6a,b: je ein Detail aus Figur 5 in unterschiedlicher Darstellung;
- Fig. 7: eine weitere perspektivische Schnittansicht auf die Anordnung aus Figur 1 in dem Endmontagezustand und
- Fig. 8: ein Detail aus Figur 7.

Im Folgenden wird die Erfindung mit Bezug auf die Figuren näher erläutert, wobei gleiche Bezugszeichen in den Figuren auf gleiche funktionale und/oder strukturelle Merkmale hinweisen.

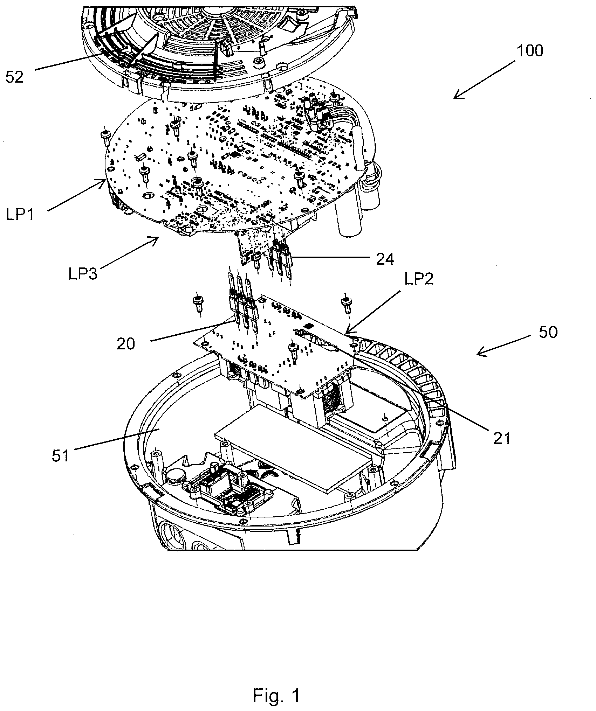

In der Figur 1 ist eine Leiterplattenanordnung 100 aus drei Leiterplatten LP1, LP2, LP3 in Superposition in einem Vormontagezustand gezeigt. Diese Leiterplatten LP1, LP2, LP3 dienen zur Ausbildung einer Motorsteuerung in einem Motorgehäuse 50 zwischen einem Gehäusetopf 51 und einem als Berührschutz ausgebildeten Gehäusedeckel 52. Die Leiterplatten LP1, LP2, LP3 sind allesamt bestückte Leiterplatten, wobei die zweite Leiterplatte LP2 mit zwei Reihen an jeweils 3 Kontaktelementen 20 ausgebildet ist, die zum Zusammenstecken in Steckrichtung S zur Herstellung einer wieder lösbaren elektrischen Verbindung mit korrespondierenden Gegenkontakten 10 der ersten Leiterplatte LP1 dienen.

Die erste Leiterplatte LP1 ist die Hauptplatine, die zweite Leiterplatte LP2 ist als Drosselleiterplatte ausgestaltet und die dritte (stehende) Leiterplatte LP3 ist die Controller-Leiterplatte, die als plattenförmigen Ausricht- und Führungseinrichtung dient.

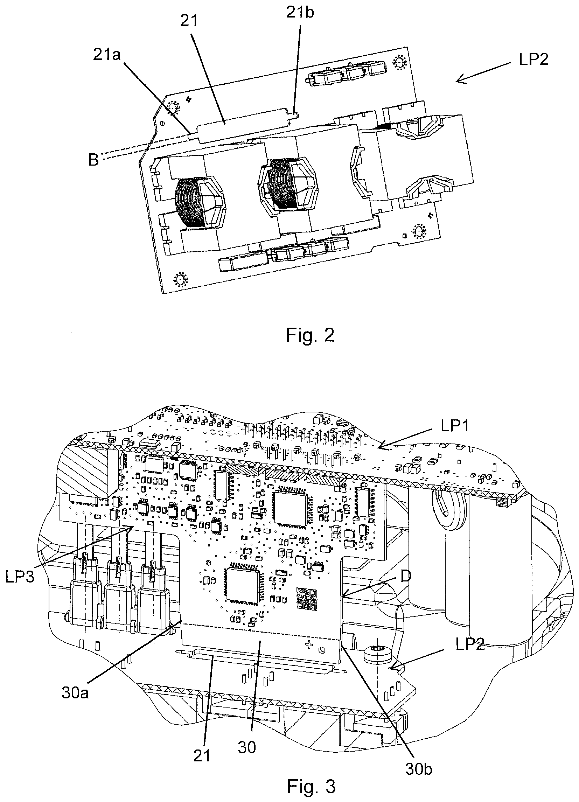

Hierzu steht die dritte Leiterplatte LP3, wie in der Figur 3 gut zu erkennen, von der ersten Leiterplatte LP1 in Steckrichtung S hervor und zwar hin zur zweiten Leiterplatte LP2. Die dritte Leiterplatte LP3 besitzt an ihrem freien Ende einen nicht bestückten Leiterplattenabschnitt und zwar endseitigen Abschnitt 30. Dieser wird in den Spalt 20, der darunter dargestellten zweiten Leiterplatte LP2 eingeführt und dann werden die Leiterplatten LP1 und LP2 zusammengesteckt. In der Figur 2 ist gut zu erkennen, dass an den beiden gegenüberliegenden Spaltenden 21a, 21 b des Spalts 21 die Breite B des Spaltes geringer ist, als in dem Bereich dazwischen und etwa der Dicke D der dritten Leiterplatte LP3 entspricht.

Weiter zu erkennen sind die beiden sich gegenüberliegenden Seitenkanten 30a, 30b der dritten Leiterplatte LP3, die in einem oberen Bereich (nahe der ersten Leiterplatte LP1) parallel verlaufen und dann im Bereich des endseitigen Abschnitt 30 nicht parallel zueinander verlaufen, sondern als Einführschräge unter einem schrägen Winkel zur Steckrichtung S, sozusagen aufeinander zu laufen.

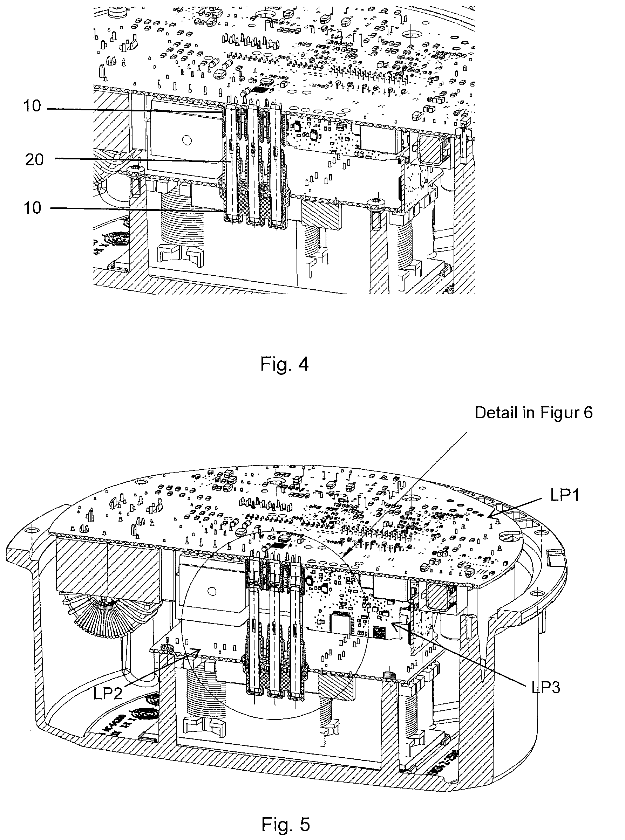

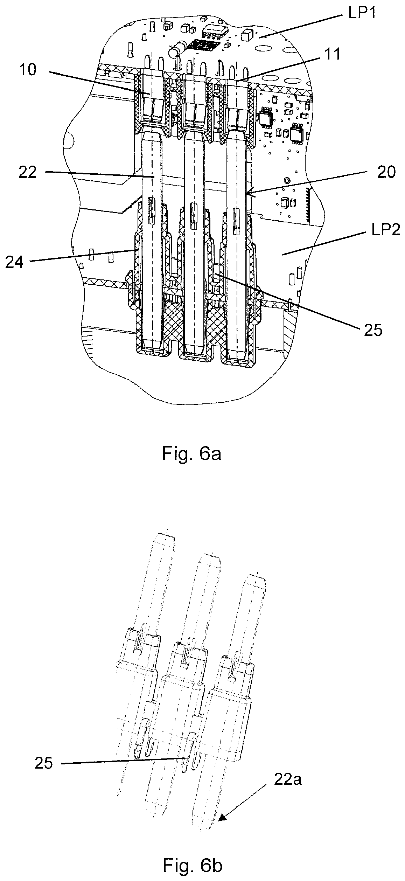

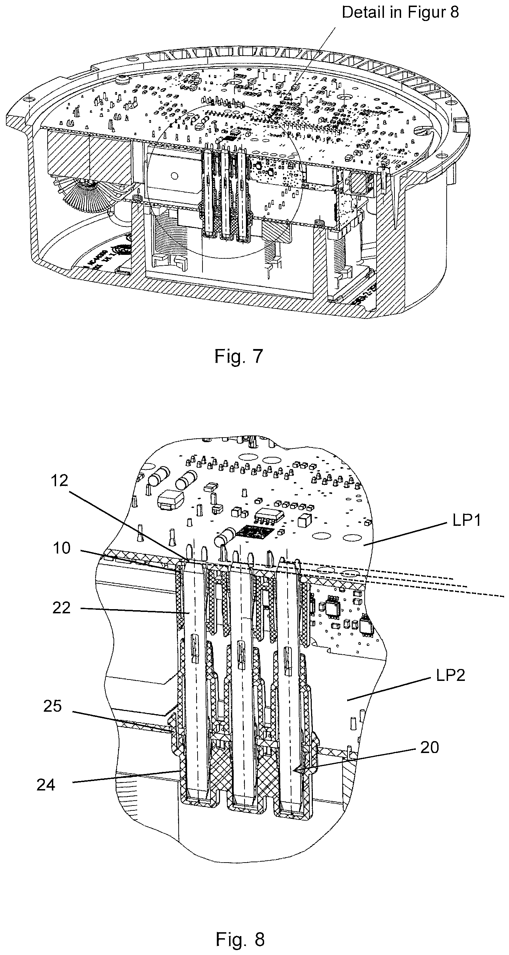

In der Figur 4 ist ein Detail-Ausschnitt in einer Schnittansicht im zusammengesteckten Zustand der Leiterplatten LP1, LP2 gezeigt. Gut zu erkennen ist die eine Kontaktreihe aus den drei Kontakten 20, die mit den Gegenkontakten 10 (Kontaktbuchsen 10) in den beiden Leiterplatten LP1 und LP2 elektrisch kontaktierend im Eingriff stehen. In den Figuren 5 sowie 6a,b ist ein Zustand beim Beginn des Zusammensteckens der Leiterplatten LP1, LP2 bzw. in den Figuren 7 und 8 im zusammengesteckten Montagezustand gezeigt.

In der ersten Leiterplatte LP1 sind im Bereich der federnden Buchsenkontakte 10 jeweils Durchbrüche 11 in der Leiterplatte LP1 durch die die Kontaktzungen 22 hindurchtreten können. Die drei Kontakte 20 stehen alle mit einer unterschiedlichen Länge von der Leiterplatte LP2 hervor, wobei die Längenunterschiede zwischen den Kontakten 20 als jeweils äquidistanter Längenunterschied ΔL vorgesehen sind (was durch die Strichlinien verdeutlicht werden soll). Beim Zusammenstecken kommen diese daher sukzessive nacheinander in Eingriff, und ragen im Endzustand unterschiedlich weit durch die Leiterplatte LP1 hindurch und zwar durch die Durchbrüche 11 in der Leiterplatte LP1 hindurch, wie dies gut im Detail der Figur 8 erkennbar ist.

Die Kontakte 20 sind als Messerkontakte bzw. als Flachkontakte über die gesamte Länge mit jeweils zwei endseitig angeordneten flachen Kontaktzungen 22 ausgebildet und sind in einem Kontaktträger 24 gelagert. Der gemeinsame Kontaktträger 24 besitzt Rastmittel 25, mit denen der Kontaktträger 24 an der Leiterplatte LP2 befestigt ist.

## Patentansprüche

1. Leiterplattenanordnung (100) zur Ausbildung einer Motorsteuerung in einem Motorgehäuse (50) bestehend aus wenigstens einer ersten bestückten Leiterplatte (LP1) und einer zweiten bestückten Leiterplatte (LP2) ausgebildet mit einer Mehrzahl an Kontaktelementen (20), ausgebildet zum Zusammenstecken in Steckrichtung (S) zur Herstellung einer wieder lösbaren elektrischen Verbindung mit korrespondierenden Gegenkontakten (10) der ersten Leiterplatte (LP1), sowie einer plattenförmigen Ausricht- und Führungseinrichtung (LP3), die von der ersten Leiterplatte (LP1) in Steckrichtung (S) hin zur zweiten Leiterplatte (LP2) hervorsteht und im Montagezustand, wenn sich die Kontaktelemente (20) der zweiten Leiterplatte (LP2) vollständig im gesteckten Zustand mit den Gegenkontakten (10) der ersten Leiterplatte (LP1) befinden, mit einem endseitigen Abschnitt (30) durch einen Spalt (21) in der zweiten Leiterplatte hindurch ragt, wobei die Kontaktelemente (20) mit einer unterschiedlichen Länge (L1, L2, L3,...) von der zweiten Leiterplatte (20) hervorstehen.

2. Leiterplattenanordnung (100) nach Anspruch 1, **dadurch gekennzeichnet, dass** die plattenförmigen Ausricht- und Führungseinrichtung (LP3) ebenfalls eine Leiterplatte, insbesondere eine bestückte Leiterplatte ist.

3. Leiterplattenanordnung (100) nach Anspruch 2, **dadurch gekennzeichnet, dass** der endseitiger Abschnitt (30) der Leiterplatte (LP3) unbestückt ist.

4. Leiterplattenanordnung (100) nach einem der vorhergehenden Ansprüche 1 bis 3, **dadurch gekennzeichnet, dass** die Spaltbreite (B) des Spaltes (21) in der zweiten Leiterplatte (LP2), so bestimmt ist, dass eine Ausrichtung und Führung des endseitigen Abschnitt (30) der Ausricht- und Führungseinrichtung (LP3) beim Zusammenstecken der ersten und zweiten Leiterplatten (LP1, LP2) bewirkt wird, insbesondere so bestimmt ist, das die Plattendicke (D) im Bereich des endseitigen Abschnitt (30) nur geringfügig kleiner als die Spaltbreite (B) ist.

5. Leiterplattenanordnung (100) nach einem der vorhergehenden Ansprüche, **dadurch gekennzeichnet, dass** die Spaltbreite (B) in einem Bereich zwischen den beiden Spaltenden (21a, 21b) größer, insbesondere 1,5 bis 2,5 mal so groß gewählt ist, wie im Führungsbereich an den Spaltenden (21a, 21b).

6. Leiterplattenanordnung (100) nach einem der vorhergehenden Ansprüche, **dadurch gekennzeichnet, dass** die sich gegenüberliegenden Seitenkanten (30a, 30b) der Ausricht- und Führungseinrichtung (LP3) im Bereich des endseitigen Abschnitt (30) nicht parallel zueinander verlaufen, sondern vorzugsweise als Einführschräge unter einem schrägen Winkel zur Steckrichtung (S) aufeinander zu laufen.

7. Leiterplattenanordnung (100) nach einem der vorhergehenden Ansprüche, **dadurch gekennzeichnet, dass** n Kontakte (20) mit n > 2 von der zweiten Leiterplatte (LP2) mit jeweils unterschiedlicher Länge (L1, L2,...Ln) hervorstehen, wobei die Längenunterschiede zwischen den Kontakten (20) so gewählt ist, dass diejenigen Kontakte (20) mit einer Länge zwischen der Länge des kürzesten und längsten Kontaktes (20) sich in ihrer Länge jeweils um einen äquidistanten Längenunterschied ΔL unterscheiden, so dass beim Zusammenstecken die n Kontakte (20) sukzessive nacheinander in Eingriff kommen.

8. Leiterplattenanordnung (100) nach einem der vorhergehenden Ansprüche, **dadurch gekennzeichnet, dass** die Kontakte (20) als Messerkontakte oder Flachkontakte mit jeweils zwei endseitig angeordneten flachen Kontaktzungen (22) ausgebildet sind, die im zusammengesteckten Zustand der ersten und zweiten Leiterplatten (LP1, LP2) jeweils mit ihrer einen Kontaktzunge (22) in einen Buchsenkontakt (10) auf jeweils der ersten Leiterplatte (LP1) eintauchen und diese elektrisch kontaktieren.

9. Leiterplattenanordnung (100) nach einem der vorhergehenden Ansprüche, **dadurch gekennzeichnet, dass** um die Kontakte (20) herum ein Kontaktträger (24) angeordnet ist, der vorzugsweise ein Rastelement (25) zur mechanischen Befestigung an einer der beiden Leiterplatten (LP1, LP2) aufweist.

10. Leiterplattenanordnung (100) nach einem der vorhergehenden Ansprüche, **dadurch gekennzeichnet, dass** die erste Leiterplatte (LP1) als übergeordnete Hauptplatine der Motorsteuerung ausgebildet ist.

11. Leiterplattenanordnung (100) nach einem der vorhergehenden Ansprüche, **dadurch gekennzeichnet, dass** die zweite Leiterplatte (LP2) als DrosselLeiterplatte aufweisend wenigstens eine Drossel ausgebildet ist.

12. Leiterplattenanordnung (100) nach einem der vorhergehenden Ansprüche 2 bis 11, **dadurch gekennzeichnet, dass** die dritte Leiterplatte (LP1), die mit er ersten Leiterplatte (LP1) elektrisch und mechanisch verbunden ist, als Motor-Controller ausgebildet ist.

13. Leiterplattenanordnung (100) nach einem der vorhergehenden Ansprüche, **dadurch gekennzeichnet, dass** die erste und zweite Leiterplatte (LP1, LP2) im montierten Zustand in Parallelebenen liegen und sich die dritte Leiterplatte (LP3) oder die plattenförmigen Ausricht- und Führungseinrichtung (LP3) in einer dazu lotrechten Ebene angeordnet ist.

14. Elektronik-Gehäuse (50) für einen Elektromotor aufweisend im Gehäuse zwischen einem Gehäusetopf (51) und einem als Berührschutz ausgebildeten Gehäusedeckel (52) eine Leiterplattenanordnung (100) gemäß einem der vorhergehenden Ansprüche 1 - 13.

15. Verfahren zur Montage einer Leiterplattenanordnung (100) nach einem der vorhergehenden Ansprüche 1 - 13 mit den folgenden Schritten:
a. Einführen des endseitigen Abschnitts (30) der mit der ersten Leiterplatte (LP1) verbundenen und von dieser hervorstehenden plattenförmigen Ausricht- und Führungseinrichtung (LP3) in den Spalt (21) in der zweiten Leiterplatte (LP2) und Ausrichten der Kontakte (20) der zweiten Leiterplatte (LP2) zu den Gegenkontakten (10) der ersten Leiterplatte (LP1)
b. sukzessives Zusammenstecken der Kontakte (20) mit den Gegenkontakten (10) bis alle Kontakte (20) vollständig eingesteckt sind.
